Europäisches Patentamt

European Patent Office

Office européen des brevets

(19)

(11) Publication number: **0 392 468**
A2

# EUROPEAN PATENT APPLICATION

(21) Application number: **90106870.0**

(22) Date of filing: **10.04.90**

(51) Int. Cl.⁵: **H01L 21/76, H01L 21/74, H01L 27/06**

(30) Priority: **10.04.89 JP 90218/89**

(43) Date of publication of application:
**17.10.90 Bulletin 90/42**

(84) Designated Contracting States:
**DE FR GB**

(71) Applicant: **Kabushiki Kaisha Toshiba
72, Horikawa-cho Saiwai-ku
Kawasaki-shi(JP)**

(72) Inventor: **Kihara, Kazuo, c/o Intellectual
Property Div.**

**Kabushiki Kaisha Toshiba, 1-1 Shibaura
1-chome
Minato-ku, Tokyo 105(JP)**
Inventor: **Taguchi, Minoru, c/o Intellectual
Property Div.**
**Kabushiki Kaisha Toshiba, 1-1 Shibaura
1-chome
Minato-ku, Tokyo 105(JP)**

(74) Representative: **Lehn, Werner, Dipl.-Ing. et al
Hoffmann, Eitle & Partner Patentanwälte
Arabellastrasse 4
D-8000 München 81(DE)**

(54) Composite type semiconductor device having electric isolation layer.

(57) According to a composite type semiconductor device of the present invention, a buried layer (10) of a second conductive type opposite to the first conductivity type is formed in a region under a major surface of a semiconductor substrate 1 of a first conductivity type, and a conductive layer (11) in which a well region or the like is formed is formed on the buried layer (10). Trench grooves (6) extending into the semiconductor substrate (1) from a surface of the conductive layer (11) through the buried layer (10) are formed, and an insulating film (7b) is formed on side and bottom surfaces of each groove. Poly-silicon (7a) is filled in the grooves to form isolation layers (7) each made of the insulating film (7b) and the poly-silicon (7a). The conductive layer (11) and the buried layer (10) are divided into islands by the isolation layers (7). On these regions, a charge coupled device region (4) having a bipolar transistor, a bipolar element region (5), and element regions (2 and 3) of a MOS structure are formed in a CMOS structure. This composite type semiconductor device can be stably driven with a voltage of 5 V.

F I G. 1

F I G. 2A

EP 0 392 468 A2

The present invention relates to a composite type semiconductor device constituted by a charge coupled device, a bipolar element, an element having a MOS structure or the like and, more particularly, to a composite type semiconductor device having an electric isolation layer which can be driven with a low power.

A composite type semiconductor device is used as a reception signal processing device used in, e.g., a television set or a video cassette recorder. The composite type semiconductor device is an integrated circuit device having the following arrangement. A CCD delay line element having a gate arranged outside a charge coupled device (to be referred to as a CCD hereinafter) region, a sample and hold circuit, an output circuit, a clock driver circuit and the like are monolithically formed on a semiconductor substrate.

A conventional CCD delay line element is driven at a supply voltage of 12 V or 9 V, and some processing signals are delayed. Many other signals are processed by a bipolar IC. The composite type semiconductor device must have a C-MOS structure, since power consumption must be reduced to improve a degree of integration. Along with this, the supply voltage of the CCD delay line element is standardized to that of the supply voltage of the bipolar IC, and the supply voltage of the CCD delay line element is set to be 5 V.

The composite type semiconductor device is constituted in the following manner. A p-channel MOS transistor region, an n-channel MOS transistor region and a delay line element region having a gate in a CCD are mounted on a semiconductor substrate to have a C-MOS structure.

In the composite type semiconductor device, however, the range capable of holding linearity of output characteristics (amplification factor or the like) of the MOS transistor is decreased to 1 to 1.4 Vpp (peak to peak) when the power source is set at 5 V. When resistance for defining an operating point has an error, the operating point is deviated from a constant value, and its output waveform may be distorted. In particularly, linearity of output characteristics of an operational amplifier constituted by MOS transistors used in the sample and hold circuit and the output circuit is largely degraded, and a composite type semiconductor device is therefore caused not to be stably driven.

In a composite type semiconductor device having a conventional structure, an isolation leak current of about $1 \times 10^{-10}$ A supplied from an electrically isolated p-n junction is supplied. In a C-MOS composite type semiconductor device, noise which influences its performance characteristics may be generated.

In the manufacture of the composite type semiconductor device having a conventional structure, annealing is performed in some steps. For this reason, a buried layer arranged under each element is expanded to an upper layer upon diffusion, thereby decreasing the thickness of a conductive layer for trapping charge. This depends on annealing temperatures and, more particularly, a processing time.

As described above, in the conventional semiconductor device, performance characteristics are not adversely affected by its power source voltage. However, since a power source voltage is reduced to improve power consumption, the composite type semiconductor device is often erroneously operated to cause an operation failure. As a result, errors of the composite type semiconductor device are detected at a step in a wafer test during the manufacture of the devices, thereby largely decreasing a yield.

It is an object of the present invention to provide a composite type semiconductor device which has low power consumption and is stably driven with a low voltage.

According to the present invention, a buried layer of a second conductivity type opposite to the first conductivity type is formed on a major surface of a semiconductor substrate of a first conductivity type. A second conductive layer of the second conductivity type on which a well region or the like is formed is formed on the resultant structure. Trench grooves reaching inside of the semiconductor substrate from the surface of the second conductive layer through the buried layer are formed, and insulating films are respectively formed on the surfaces of side walls and bottoms of the grooves. These grooves are filled with poly-silicon to form isolating layers each constituted by the insulating film and the poly-silicon. There is provided to a composite type semiconductor device in which a CCD region formed by employing bipolar transistors, a bipolar element region, and an element region having a MOS structure are respectively formed in regions which are isolated by the isolating layers and each of which is constituted by the second conductive layer and the buried layer.

This invention can be more fully understood from the following detailed description when taken in conjunction with the accompanying drawings, in which:

Fig. 1 is a sectional view showing a composite type semiconductor device according to an embodiment of the present invention,. and

Figs. 2A to 2G are views for explaining the steps in manufacturing the composite type semiconductor device of the present invention shown in Fig. 1.

An embodiment of the present invention will be described below with reference to the accompanying drawings.

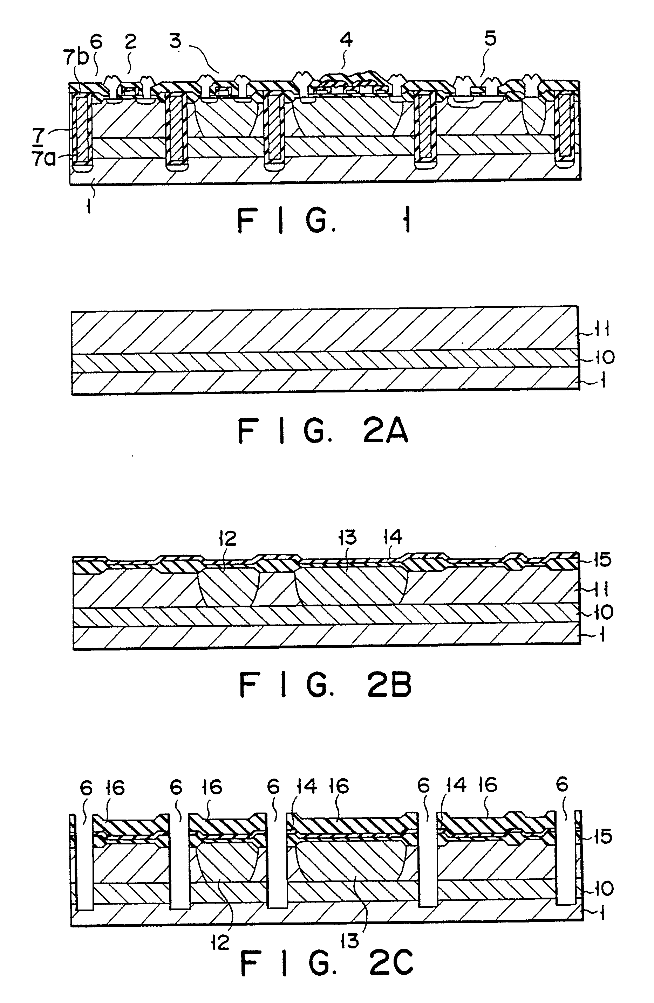

Fig. 1 shows a sectional structure of a composite type semiconductor device according to the embodiment of the present invention. That is, the composite type semiconductor device is manufactured so that a p-channel MOS transistor region 2, an n-channel MOS transistor region 3, a charge coupled device region 4, and a bipolar IC region 5 are monolithically formed on a semiconductor substrate 1.

Trench grooves 6 are formed between the regions, and an isolation layers 7 each formed by covering a poly-Si core 7a with an insulating film 7b are respectively formed in the trench grooves 6. The regions are divided into island regions to be electrically isolated.

Figs. 2A to 2G are views for explaining the steps in manufacturing the composite type semiconductor device according to the embodiment of the present invention shown in Fig. 1. Reference numerals in Figs. 2A to 2G denote the same parts as in Fig. 1.

In the step in Fig. 2A, phosphorus (P) is diffused in the major surface of the p-type semiconductor substrate 1 to form an $n^+$-type impurity layer (a buried layer 10 to be described later) 10 having a surface concentration of about $1 \times 10^{19}$ - (atoms/cc) near the major surface. In addition, an $n^-$-type impurity layer 11 containing phosphorus (P) of about $1 \times 10^{16}$ (atoms/cc) is deposited on the entire surface of the impurity layer 10 by epitaxial growth. In this step, the impurity contained in the $n^+$-type impurity layer 10 is automatically doped in the $n^-$-type impurity layer 11.

In the step in Fig. 2B, an oxide film having a thickness of about 500 A is formed on the $n^-$-type impurity layer 11. A mask (not shown) made of a resist is selectively formed on the oxide film and boron (B) ions are implanted in the impurity layer 11. Thus, p-well regions 12 and 13 each having a resistivity of about 10 cm are formed in the $n^-$-type impurity layer 11. After removing the resist, a silicon nitride ($Si_3N_4$) film is formed. A PEP is performed to leave the silicon nitride film over the p-channel MOS transistor region 2, the n-channel MOS transistor region 3, the charge coupled device region 4, and the bipolar IC region 5 as a mask. Thereafter, a selective oxide layer 15 having a thickness of 5,000 Å to 10,000 Å is formed to serve as an isolation or field region for isolating element regions from each other.

In the step in Fig. 2C, a resist 16 used as a mask for forming windows in the selective oxide layer 15 to selective expose the surface of the semiconductor substrate 1.

A trench grooves 6 are formed in the selective oxide layer 15 by anisotropic etching using a $CHF_3$ as a process gas. After removing the resist 16, anisotropic etching is performed using the thermal oxide film 14 and the selective oxide layer 15 as masks and using $CBrF_3$ as a process gas. Thus, the trench grooves 6 are formed to have a depth to reach inside the p-type semiconductor substrate 1 through the $n^-$-type impurity layer 11 and the $n^+$-type buried layer 10. The trench grooves 6 must be formed to have a depth enough to extend over a p-n junction between the $n^+$-type buried layer 10 and the major surface of the p-type semiconductor substrate 1 into the p-type semiconductor substrate 1.

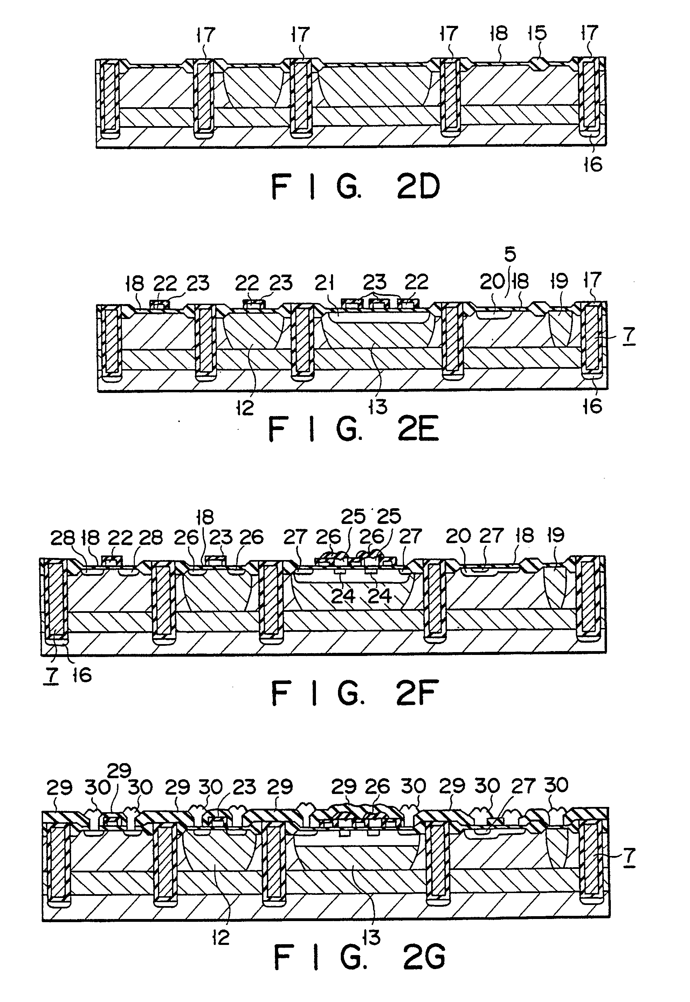

In the step in Fig. 2D, the oxide film 7b having a thickness of about 2,000 Å is formed on the surface of each of the trench grooves 6 by thermal oxidation. Ions are implanted in the bottom of each trench groove 6. That is, boron (B) ions are implanted in a direction toward the bottom of each trench groove 6 (a direction perpendicular to the major surface of the semiconductor substrate 1) at a dose of about $1 \times 10^{15}$/cm$^2$ and an acceleration voltage of 150 keV. The resultant structure is annealed in an atmosphere of an inert gas such as Ar gas at a temperature of 1,000°C for 30 minutes. As a result, a channel stopper 16 for preventing to invert the p-type semiconductor substrate 1 into an $n^+$-type substrate is formed in the bottom of each trench groove 6. Each trench groove 6 in which the oxide film 7b is formed is filled with poly-Si to form the poly-Si layer 7a. In addition, an oxide film 17 having a thickness of about 2,000 Å is formed on the upper surface of each poly-Si layer 7a by thermal oxidation.

Therefore, the $n^+$-type buried layer 10 and the $n^-$-type impurity layer 11 are formed as regions (isolated islands) electrically isolated from each other by isolation layers 7 each made of the poly-Si layer 7a, the oxide film 7b and the oxide film 17. A gate oxide film 18 is formed on the thermal oxide film 14 by thermal oxidation.

From the step in Fig. 2E, elements are formed. That is, phosphorus ($^{31}P^+$) ions are implanted in a predetermined position within the bipolar IC region 5 at an acceleration voltage of 50 keV and a dose of $5 \times 10^{15}$cm$^{-2}$ to form an n-p-n type transistor deep region 19 having a surface concentration of about $1 \times 10^{20}$ (atoms/cc). Similarly, by implantation of boron (B) ions, a base region 20 having a surface concentration of about $1 \times 10^{16}$ (atoms/cc) is formed. In addition, phosphorus ($^{31}P^+$) ions are implanted in a predetermined position within the charge coupled device region 4 at an acceleration voltage of 160 keV and a dose of $1 \times 10^{13}$cm$^{-2}$ to form a buried channel 21 having a surface concentration of about $1 \times 10^{16}$ (atoms/cc).

First gates 22 made of poly-Si are formed on the gate oxide film 18 on the p-channel MOS transistor region 2, the n-channel MOS transistor region 3 and the charge coupled device region 4.

Thereafter, the semiconductor substrate 1 is annealed in an oxygen atmosphere at a temperature of $900^\circ$C to $1,000^\circ$C, and an oxide film 23 is formed on each first gate 22.

In the step in Fig. 2F, boron (B) ions are implanted in the charge coupled device region 4 using the first gate 22 and the oxide film 23 as masks to self-align a delay element barrier implantation region 24 having a surface concentration of about $1 \times 10^{16}$ (atoms/cc) in the buried channel 21. Second gates 25 made of poly-Si are formed on the oxide film 23 between the first gates 22 by known photoengraving process. In addition, an insulating film 26 is formed to cover the upper surface of each second gate 25.

Phosphorus (P) ions are implanted in the n-channel MOS transistor region 3, the charge coupled device region 24 and the bipolar IC region 5 using the oxide films 23 and 26 as masks. By this ion implantation, $n^+$-type regions 27 each having a surface concentration of about $1 \times 10^{21}$ (atoms/cc) are self-aligned on both the sides of the first gates 22 and the second gates 25.

Boron (B) ions are implanted in the p-channel MOS transistor region 2 using the first gate 22 as a mask. By this ion implantation, p-type regions 28 each having a surface concentration of about $1 \times 10^{19}$ (atoms/cc) are self-aligned on both the sides of the first gate 22 and annealed.

In the step in Fig. 2G, an insulating layers 29 are deposited on the oxide films 15 and 17 by a CVD (Chemical Vapor Deposition) device. Wiring layers 30 are formed on each of the element regions, thus finishing a composite type semiconductor device. Each of the wiring layers 30 is formed using Aℓ or an Aℓ alloy (Aℓ-Si or Aℓ-Si-Cu) by a sputtering device or the like. A composite type semiconductor substrate formed on a p-type semiconductor substrate has been described above. An n-type semiconductor substrate may be used. That is, the same effect as described above can be obtained, even if elements are formed on an n-type Si substrate.

According to a composite semiconductor device of the present invention, since a charge coupled device is electrically isolated from a bipolar IC by an isolation layer of a trench groove, an annealing time is shorter than that in isolation using a conventional p-n junction structure. Therefore, an impurity ($N^+$) of a buried layer is not diffused upward to the upper surface thereof during annealing, a predetermined thickness of the conductive layer is maintained enough to trap charges. In addition, a sufficiently high breakdown voltage of an n-p-n type transistor formed in a bipolar IC region can be obtained.

By applying this embodiment, in an operation amplifier used in a sample and hold circuit and an output circuit in the composite semiconductor device, the MOS transistor structure is converted into a bipolar transistor structure. Therefore, even when a power source voltage is decreased, linearity of output characteristics (e.g., amplification factor) can be assured within a sufficient range. The linearity dose not fall outside the range even if errors in resistance for defining an operating point occur, and an output waveform is not distorted.

As described above, according to the composite type semiconductor device, even when a power source voltage is decreased to improve power consumption, performance characteristics are not adversely affected. Therefore, operational errors are largely decreased, and about a 90% yield of products can be obtained in a wafer test during the manufacture.

The present invention is not limited to the above embodiment, and simplification of a signal processing system in a VTR and an application to a TV movie camera can be facilitated.

Reference signs in the claims are intended for better understanding and shall not limit the scope.

## Claims

1. A composite type semiconductor device having isolation layers comprising:
a semiconductor substrate (1) of a first conductivity type;
a buried layer (10) of a second conductivity type opposite to the first conductivity type formed in a region under a major surface of said semiconductor substrate (1); and
a conductive layer (11) of the second conductivity type formed on said buried layer of the second conductivity type; characterized by further comprising
isolation layers (7) in which insulating films (7b) are formed on the side and bottom surfaces of grooves (6) extending into said semiconductor substrate from a surface of said conductive layer (11) through said buried layer (10), and poly-silicon (7a) is filled in said grooves; and
a charge coupled device (4) region, a bipolar element (5) region, and an element (2 and 3) region having a MOS structure, said charge coupled device (4), bipolar element (5), and element regions being respectively formed on island regions each constituted by said conductive layer (11) and said buried layer (10) and being isolated from each other by said isolation layers (7).

2. A device according to claim 1, characterized in that said buried layer (10) of the second conductivity type includes an isolation layer deposited and formed on said major surface of said semiconductor substrate.

3. A device according to claim 1, characterized in that said conductive layer (11) of the second conductivity type comprises an epitaxial layer.

4. A device according to claim 1, characterized in that a channel stopper (16) for preventing to invert a conductivity type is formed in a bottom of each of said isolation layers (7).

5. A device according to claim 1, characterized in that operational amplifiers used in a sample and hold circuit and an output circuit formed in said charge coupled device (4) region are constituted by bipolar transistors.

6. A device according to claim 1, characterized in that said isolation layer (7) is constituted by an insulating layer made of only an insulator.

7. A device according to claim 1, characterized in that said isolation layer (7) is constituted by an isolating layer made of only poly-Si.

8. A device according to claim 1, characterized in that said isolation layers (7) are formed to cause said conductive layer (11) and said buried layer (10) to form a matrix.

9. A device according to claim 1, characterized in that said isolation layer (7) is arranged along a field oxide film (15) region constituted by an insulating layer (17) formed on said conductive layer (11) of the second conductivity type.

F I G. 1

F I G. 2A

F I G. 2B

F I G. 2C

## F I G. 2D

17    17    17    18    15    17

16

## F I G. 2E

18 22 23    22 23    21    23 22    20 18    19 17

5

7

12    13    16

## F I G. 2F

28 18 22 28    26 23 26    27 26 26 27    20 27 18 19

18    25 25

24 24

7 16

## F I G. 2G

29    30 30    29 30 23 29    29 26 30    29 30 27 30

29

7

12    13